(19) Europäisches Patentamt

European Patent Office

Office européen des brevets

(11) Veröffentlichungsnummer: **0 058 231**
**B1**

(12) # EUROPÄISCHE PATENTSCHRIFT

(45) Veröffentlichungstag der Patentschrift:
**28.12.88**

(51) Int. Cl.⁴: **H 01 L 33/00**

(21) Anmeldenummer: **81108442.5**

(22) Anmeldetag: **16.10.81**

(54) **Herstellung von Lumineszenz- oder Laserdioden mit intern begrenzter Leuchtfläche.**

(30) Priorität: **17.02.81 DE 3105786**

(43) Veröffentlichungstag der Anmeldung:
**25.08.82 Patentblatt 82/34**

(45) Bekanntmachung des Hinweises auf die Patenterteilung:
**28.12.88 Patentblatt 88/52**

(84) Benannte Vertragsstaaten:
**FR GB IT**

(56) Entgegenhaltungen:
EP-A- 0 038 085
FR-A- 2 316 747
GB-A- 2 053 564
US-A- 4 194 933
US-A- 4 249 967

REVIEW OF THE ELECTRICAL COMMUNICATION
LABORATORIES, Band 27, Nr. 7-8, Juli-August 1979,
Seiten 569-585, Tokyo, JP; KUNISHIGE OE u.a.:
"GaInAsP/InP optical sources for 1.2-1.4 mum
wavelength region"

(73) Patentinhaber: **Siemens Aktiengesellschaft Berlin und
München, Wittelsbacherplatz 2, D-8000 München 2 (DE)**

(72) Erfinder: **Heinen, Jochen, Dr.-Ing., Dianastrasse 38,
D-8013 Haar (DE)**

**Beschreibung**

Die vorliegende Erfindung bezieht sich auf ein Verfahren zur Herstellung einer pn-Lumineszenz -oder Laserdiode.

Aus dem Stand der Technik ist es bekannt, Lumineszenzdioden herzustellen, in denen nur eine lateral eng begrenzte Zone des im Halbleiterkörper vorhandenen, für Lichtemission an sich in Frage kommenden (Schicht-)Bereichs zur Strahlungserzeugung aktiviert werden kann. Die Eingrenzung dieser Zone im Halbleiterkörper erfolgt nach dem Stand der Technik dadurch, dass eine Schichtfolge mit mehrfach abwechselndem Leitungstyp vorgesehen wird, die wenigstens einen sperrenden PN-Übergang hat. Dieser sperrende Übergang der Schichtfolgen fehlt jedoch an der Stelle, wo in dem Halbleiterkörper die begrenzte aktivierbare Zone bzw. Leuchtfläche vorhanden sein soll. Das Herstellungsverfahren einer solchen bekannten Lumineszenzdiode besteht im wesentlichen aus einem ersten Verfahrensschritt, der eine epitaxiale Abscheidung wenigstens einer Halbleiterschicht auf dem Substratkörper betrifft. Daraufhin wird der beschichtete Substratkörper aus der Epitaxie-Apparatur herausgenommen und einem Ätzprozess unterworfen, in dem ein Anteil der zuvor epitaktisch aufgebrachten Schicht wieder beseitigt wird. Dann wird der Substratkörper wieder in eine Epitaxie-Apparatur eingebracht und es werden die weiteren notwendigen, an sich bekannten Schichten der restlichen Schichtfolge auf der schon vor dem Ätzvorgang aufgebrachten Schicht und auf dem durch Ätzen entstandenen Flächenanteil abgeschieden. Diesbezüglich sei auch auf die Druckschrift «NTZ», Bd. 31 (1978), Heft 2, Seiten 129/130, insbesondere Fig. 2, hingewiesen. Eine solche bekannte Lumineszenzdiode ist ebenso wie die nach dem noch nachfolgend zu beschreibenden Verfahren der Erfindung hergestellte Diode wegen der lateral eng begrenzten Leuchtfläche in besonderem Masse dazu geeignet, mit einer Glasfaser zwecks Strahlungsübertragung gekoppelt zu werden (wie dies insbesondere auch Fig. 1 dieser Druckschrift zeigt). Die erwähnte Fig. 2 der Druckschrift lässt das Vorhandensein eines PN-Übergangs erkennen, der sich neben bzw. rund herum um die dort mit 50 $\mu$m Durchmesser bemessene Ätzung befindet, wobei diese Ätzzone die oben erwähnte aktive Emissionszone bzw. die Leuchtfläche bestimmt und definiert. Die in Fig. 2 der Druckschrift gezeigten übrigen Schichten aus N-Gallium-Aluminiumarsenid und aus P-Gallium-Aluminiumarsenid bilden die weitere an sich bekannte Schichtfolge, wie sie u.a. auch für die nach dem Verfahren der Erfindung herzustellende Diode vorgesehen sind. Entsprechendes gilt auch für die dort gezeigten Elektroden zur Stromzuführung.

In der Patentschrift US-A-4 194 933 und der korrespondierenden Veröffentlichung von W.T. Tsang und R.A. Logan: «Lateral current confinement by reverse-biased junctions in GaAs-Al$_x$Ga$_{1-x}$As DH lasers», Appl. Phys. Lett. 30, 538 bis 540 (1977) ist ein DH-Laser mit seitlicher Strombegrenzung durch sperrende pn-Übergänge beschrieben. Auf ein Substrat mit einer ausgeätzten Mesa wird eine Halbleiterschicht des entgegengesetzten Leitungstyps aufgewachsen. Die Autoren geben an, dass auf der Oberfläche der Mesa kein Halbleitermaterial aufwachse, da dort anscheinend die Kristallisation verhindert sei und sich so in dem aufgewachsenen pn-Übergang automatisch längs der Mesa ein streifenförmiges Fenster ergebe. Es werden keine Gründe genannt, warum bei der Durchführung dieses Verfahrensschrittes kein Aufwachsen auf der Mesa-Oberfläche erfolgte, obwohl die Materialzusammensetzung des Substrates homogen war und bei dem üblichen Flüssigphasenepitaxieverfahren normalerweise die gesamte mit der Schmelze in Berührung kommende Substratoberfläche mit Material aus der Schmelze überwachsen wird. Auf die erste aufgewachsene Schicht und nun auch auf die Mesa-Oberfläche wird wie üblich eine Schichtfolge für einen DH-Laser aufgewachsen. Abschliessend wird ein weiterer bei Betrieb des Lasers in Sperrichtung gepolter pn-Übergang geschaffen, in den ein kollinear zur Substrat-Mesa verlaufendes streifenförmiges Fenster geätzt wird. Abschliessend erfolgt die Kontaktierung.

Aufgabe der vorliegenden Erfindung ist es, ein solches Verfahren zur Herstellung einer an sich bekannten Lumineszenz- oder Laserdiode mit einem durch pn-Übergänge seitlich begrenzten Emissionsbereich anzugeben, das mit stets wiederholbarem Erfolg durchführbar ist und bei dem die begrenzten pn-Übergänge hergestellt werden, ohne dass das Substrat zwischen den Epitaxieschritten aus der Epitaxievorrichtung entfernt werden muss.

Diese Aufgabe wird mit einem Verfahren mit den Merkmalen des Patentanspruches 1 bzw. 2 gelöst. Weitere Ausgestaltungen gehen aus den Unteransprüchen hervor.

Das jeweils in den Patentansprüchen 1 und 2 verkörperte gleiche Prinzip der Erfindung ist, den notwendigen fotolithografischen Ätzschritt beim erfindungsgemässen Verfahren schon vor Durchführung der notwendigen Verfahrensschritte epitaktischer Abscheidungen vorzunehmen, so dass diese letztgenannten Verfahrensschritte kontinuierlich aufeinanderfolgend durchgeführt werden können, ohne dass der im Entstehen begriffene Halbleiterkörper aus der Epitaxie-Vorrichtung zwischenzeitlich herausgenommen werden müsste. Bei der Erfindung wird ein Mesa statt einer Grube geätzt. Ein weiteres Merkmal der Erfindung ist, die erste und/oder die zweite auf dem Ausgangs-Substratkörper abzuscheidende Epitaxieschicht in der Weise zu erzeugen, dass im Bereich des – bei der Erfindung schon vor Durchführung von Epitaxie-Schritten auf bzw. an dem Substratkörper hergestellten – Mesa eine nur dünnere Schichtdicke erzeugt wird, als dies für die dem Mesa benachbarten bzw. diesen umgebenden Bereichen dieser ersten und/oder zweiten Schicht der Fall ist. Dazugehöriges weiteres wichtiges Merkmal ist, zuvor abgeschiedene Halbleitermaterial-Anteile wieder zu entfernen, und zwar derart, dass die ohnehin bereits mit nur geringerer Dicke hergestellte einfache (Patentanspruch 1) oder doppelte (Patentanspruch 2) Beschichtung der Oberfläche des Mesa wieder gänzlich entfernt wird, so dass die Tafeloberfläche des Mesa (und damit ein Anteil ursprünglicher Substratkörper-Oberfläche) wieder freiliegt. Auf den den Mesa umgebenden Flächenanteilen der Substratoberfläche liegt dann aber Beschichtung mit einem PN-Übergang vor. Beim erfindungsgemässen Verfahren kann ohne weiteres auch noch ein Anteil Materials dieses Oberflächenbereichs des Mesa mit abgetragen werden.

Weitere Verfahrensschritte der Herstellung nach dem erfindungsgemässen Verfahren bestehen in an sich üblichen Massnahmen zur Erzeugung der Schichtfolge von Lumineszenz- oder Laserdioden, insbesondere solcher mit Hetero-Übergängen. Die lumineszenz- oder laseraktive Zone liegt in einer oder mehreren Schichten bzw. im Übergang zweier Schichten dieser weiteren Schichtfolge.

Wegen des den Mesa umgebenden PN-Übergangs liegt eine Durchflutung des Halbleiterkörpers mit elektrischem Strom nur im Querschnittsbereich dieses Mesa vor. Nebenschlüsse dazu sind durch den erwähnten PN-Übergang gesperrt. Wie bei der Diode nach dem Stand der Technik wird auch bei der nach dem einfacheren erfindungsgemässen Verfahren hergestellten Diode somit nur auf lateral eng begrenztem Bereich in dieser Diode Strahlung erzeugt.

Weitere Erläuterungen der Erfindung gehen aus der nachfolgenden, anhand der Figuren gegebenen Beschreibung je eines Ausführungsbeispiels der beiden Alternativen des erfindungsgemässen Lösungsprinzips hervor.

Fig. 1 zeigt ein Flussdiagramm des Prinzips eines Verfahrens der Erfindung.

Fig. 2 bis 6 zeigen einzelne Verfahrensschritte des erfindungsgemässen Verfahrens.

Fig. 7 zeigt eine fertige Diode.

Fig. 8 zeigt ein Temperatur-Zeitdiagramm.

Fig. 9 zeigt eine Vorrichtung zur Ausführung der Epitaxieschritte und des Schmelzätzens.

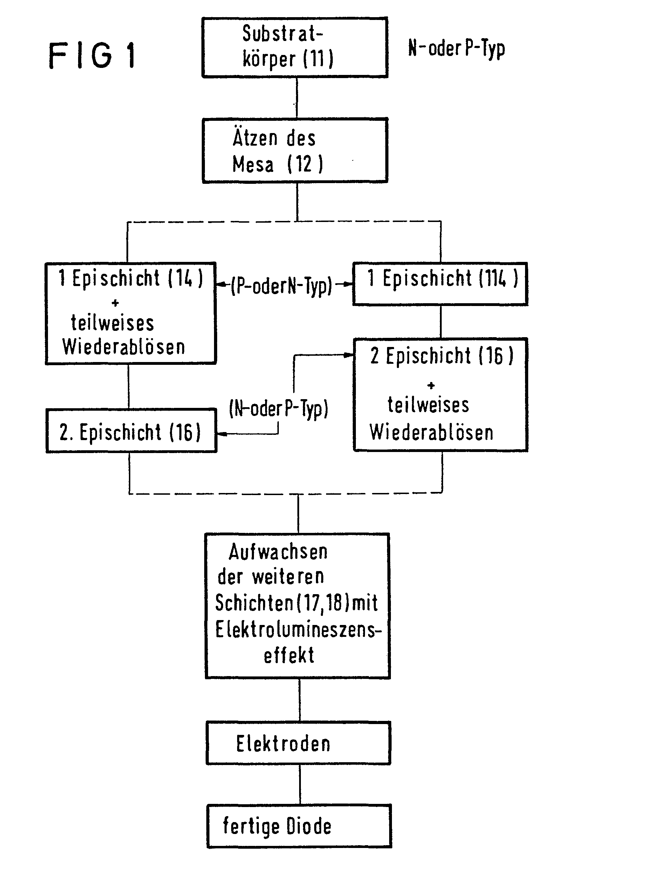

Das Flussdiagramm der Fig. 1 geht von einem Substratkörper 11 aus, der N- oder P-Leitungstyp hat. Durch Ätzen wird für die einzelne Diode der vorgesehene Mesa 12 hergestellt. Die Querschnittsfläche des Mesa wird entsprechend der geforderten Leuchtfläche bemessen. Nachfolgend wird dann eine erste Schicht 14, 114 epitaxial aufgebracht, die aus P- oder N-Typ-Halbleitermaterial besteht. Gemäss der einen Alternative (linke Spalte der Fig. 1) wird diese erste Epitaxie-Schicht so aufgebracht, dass sie auf der Oberfläche des Mesa eine geringere Schichtdicke als in der Umgebung des Mesa auf der Substratoberfläche hat. Bei der anderen Alternative (rechte Spalte der Fig. 1) kann diese erste Schicht ebenfalls auf dem Mesa geringere Dicke haben, jedoch ist dies dort mit Rücksicht auf den folgenden Verfahrensschritt noch nicht zwingend. Geringere Schichtdicke auf dem eine Erhöhung bildenden Mesa erreicht man durch relativ langsames epitaktisches Aufwachsen, das wiederum durch zeitlich relativ langsames Absenken der Temperatur der Schmelzlösung erreicht wird, aus der das abzuscheidende Material bei sinkender Temperatur ausgeschieden wird.

Bei der ersten Alternative wird in diesem Verfahrensschritt in unmittelbarer Fortsetzung einiges Material dieser ersten Schicht wieder abgelöst. Dies erfolgt durch vorübergehende Temperaturerhöhung von Schmelz und Epitaxie-Schicht, wobei eine Wiederaufnahme von zuvor ausgeschiedenem Material in die Schmelzlösung erfolgt. Wegen der geringeren Dicke der zuvor auf der Oberfläche des Mesa abgeschiedenen Schicht beseitigt das Wiederablösen jegliches auf der Mesa-Oberfläche zuvor abgeschiedenes Material der ersten Schicht bzw. es wird solange wiederabgelöst, bis dieser Zustand voll erreicht ist.

Im nächsten Verfahrensschritt wird die zweite Schicht 16 epitaxial abgeschieden, und zwar bestehend aus N- oder P-Typ-Halbleitermaterial. Bei der zweiten Verfahrensvariante wird auf dem Mesa eine dünnere Schicht abgeschieden, als dies für die Umgebung des Mesa gilt. Dies erfolgt durch wie schon beschriebenes langsames Abscheiden. Das teilweise Wiederablösen erfolgt hier so, wie dies zur ersten Variante bereits beschrieben worden ist. Bei der zweiten Variante muss durch das Wiederablösen ebenfalls die Oberfläche des Mesa soweit freigelegt werden, dass auf dem Mesa (aber nicht auf der den Mesa umgebenden Substratoberfläche) alles Material der ersten Epitaxie-Schicht (die gegenüber dem Substratkörper und dem Mesa entgegengesetzten Leitungstyp hat) beseitigt ist. Im übrigen kann beim Verfahren der ersten Variante die zweite Epitaxie-Schicht ebenfalls mit geringerer Dicke auf dem Mesa abgeschieden werden.

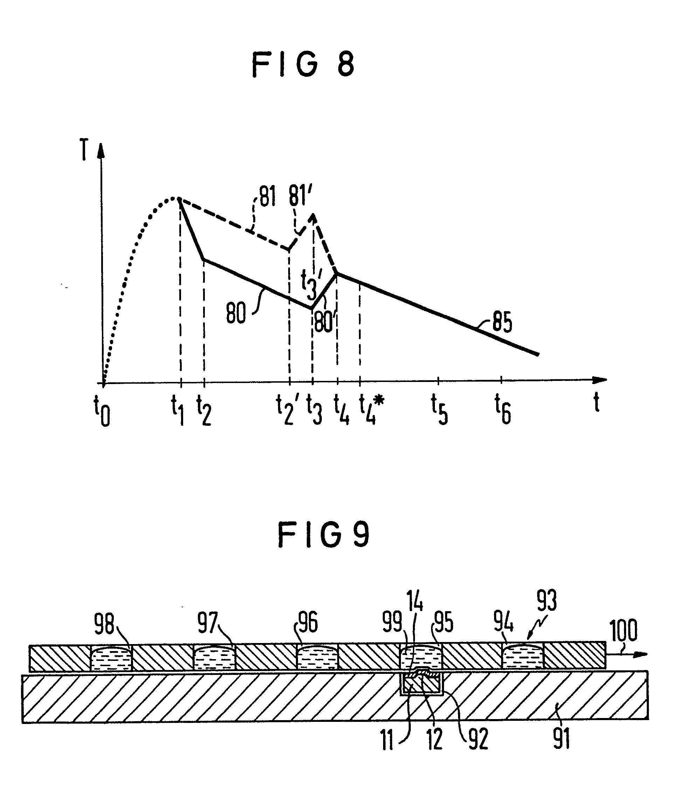

Durch das Wiederablösen wird über der Mesa-Oberfläche zwangsläufig jegliches Material der zweiten Schicht 16 entfernt (damit das Material der ersten Schicht 114 entfernt werden kann). Wenn am Ende des Wiederablösens die Schmelzlösung mit Material der zweiten Schicht 16 nicht unmittelbar entfernt (z.B. weitergeschoben, siehe Fig. 9) wird und die Temperatur von Schmelzlösung und Substratkörper 11 wieder gesenkt wird, wächst erneut Material der Schicht 16 auf, und zwar auch auf der Mesa-Oberfläche 13. Dies ist jedoch sogar von Vorteil, da damit die Schicht 16 und vor allem die Mesa-Oberfläche 13 wieder mit einer epitaktischen Schicht 116 bedeckt wird, die ohnehin gleichen Leitungstyp wie das Material des Substratkörpers 11 hat. Eine solche Epitaxialschicht bewirkt, dass eine weitere darauf abgeschiedene Epitaxie-Schicht grössere Kristallperfektion hat.

Die Wiederablösung von Material der ersten Schicht 14 (der ersten Variante) kann – wie oben erläutert – mit der Schmelzlösung erfolgen, aus der zuvor diese Schicht 14 abgeschieden worden ist. Alternativ (im Rahmen der ersten Variante) kann für dieses Wiederablösen aber auch die Schmelzlösung verwendet werden, die anschliessend für die Abscheidung der folgenden zweiten Schicht 16 verwendet wird, und zwar ebenfalls mit zeitweiser Temperaturerhöhung. Ein kleiner Nachteil ist dabei jedoch, dass dann Material der ersten Schicht 14 in der Schmelzlösung für die zweite Schicht 16 aufgenommen wird, wobei beide Schichtmaterialien für entgegengesetzten Leitungstyp dotiert sind.

Weiterhin kann als dritte Alternative für das Wiederablösen (und zwar bei beiden Varianten) auch eine gesonderte Ätz- oder Abtrageschmelze verwendet werden, wie dies im übrigen weiter unten noch eingehender erläutert wird. Mit der Ätzschmelze kann auch auf die zeitweise Temperaturerhöhung verzichtet werden.

Das soweit erreichte Ergebnis der voranstehend beschriebenen Verfahrensschritte ist, dass ein Substratkörper mit einer einem Mesa entsprechenden Erhöhung vorliegt. Ausserhalb der Mesa-Oberfläche sind zwei Schichten 14, 16 bzw. 114, 16 aus Halbleitermaterial mit zueinander entgegengesetztem Leitungstyp vorhanden, so dass dort im Betrieb ein sperrender PN-Übergang vorliegt. Auf der Oberfläche des Mesa dagegen befindet sich entweder kein Material einer abgeschiedenen Schicht (= zweite Variante) oder nur Material der zweiten Epitaxie-Schicht 16 (= erste Variante), das aber gleichen Leitungstyp wie der Substratkörper, d.h. das Material des Mesa hat. Auf dem Mesa liegt also kein PN-Übergang vor.

In den weiteren Verfahrensschritten werden dann auf der zweiten Epitaxie-Schicht 16 (erste Variante) bzw. auf der freigelegten Oberfläche des Mesa (zweite Variante) weitere Schichten 17, 18 aufgewachsen, in denen Elektrolumineszenz bei Stromdurchfluss zu bewirken ist. Zum Beispiel sind die weiteren Schichten P-, N- und/oder i-Schichten aus beispielsweise Galliumarsenid oder Indiumphosphid. Insbesondere sind die weiteren Schichten sogenannte Hetero-Schichten aus z.B. Gallium-Aluminiumarsenid oder Indium-Galliumarsenidphosphid und darauf aus P- bzw. N-leitendem Gallium-Aluminiumarsenid oder Indiumphosphid.

Nach Anbringung der Elektroden erhält man die fertige Diode.

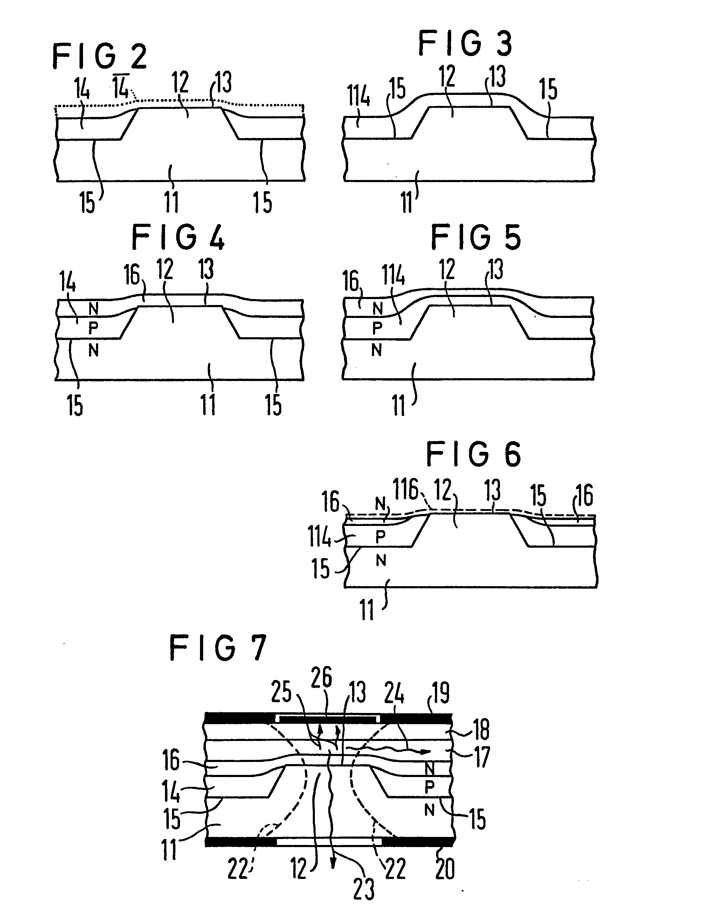

Fig. 2 und Fig. 3 zeigen gegenständlich das Ergebnis des Verfahrensschrittes der dritten Zeile der Fig. 1, und zwar Fig. 2 für die erste Alternative und Fig. 3 für die zweite Alternative.

Mit 11 ist jeweils ein Teilstück des Substratkörpers bezeichnet und mit 12 der auf bzw. an dem Substratkörper 11 befindliche Mesa mit seiner Mesa-Oberfläche 13. Mit 14 bzw. 114 ist auf die erste Epi-Schicht hingewiesen, die wegen des Wiederauflösens im Verfahrenszug der ersten Alternative in Fig. 2 zeitlich nur bis an den Mesa 12 heranreicht, so dass die Mesa-Oberfläche 13 frei von Material der Schicht 14 ist. Bei der zweiten Alternative gemäss Fig. 3 überdeckt ein Anteil der Schicht 114 auch die Mesa-Oberfläche 13, wobei die Schichtdicke der Schicht 114 über der Mesa-Oberfläche 13 auch geringer sein kann als über der übrigen Substratoberfläche 13 ausserhalb des Mesa 12. Bei der Variante gemäss Fig. 2 muss die ursprünglich erzeugte Schichtdicke der Epi-Schicht 14 über der Mesa-Oberfläche 13 vor Durchführung des Wiederablösens geringer als über der Substratoberfläche 15 gewesen sein. Mit der punktierten Linie $\overline{14}$ ist auf die in diesem Verfahrensschritt vor Wiederablösen erzeugte maximale Ausdehnung der ersten Epi-Schicht $\overline{14}$ hingewiesen. Durch diese geringere Dicke über der Substratoberfläche 13 wird nämlich sichergestellt, dass nach dem nachfolgenden Wiederablösen eines Anteils des Materials der Schicht $\overline{14}$ dann über der Substratoberfläche 15 noch eine geschlossene Schicht 14 verbleibt, obwohl auf der Mesa-Oberfläche 13 sämtliches Material der Schicht $\overline{14}$ wieder beseitigt worden ist. Dieses Aufbringen der Schicht 14 mit ihrer Aussparung der Oberfläche 13 des Mesa 12 erfolgt also ohne eine Maskierung.

Fig. 4 betrifft Verfahrensschritte der vierten Zeile der ersten Variante aus Fig. 1. Die Schicht 14 und die Mesa-Oberfläche 13 sind bereits mit der zweiten Epi-Schicht 16 bedeckt. Für ein Beispiel ausgehend von einem N-leitenden Substrat ist der jeweilige Leitungstyp der Schichten 14 und 16 eingetragen. Es kann auch der jeweils entgegengesetzte Leitungstyp vorgesehen sein. Der PN-Übergang zwischen der Schicht 14 bzw. 114 und der Schicht 16 ist deutlich erkennbar. Es ist ersichtlich, dass zwischen der Mesa-Oberfläche 13 und der Schicht 16 kein PN-Übergang vorliegt.

Fig. 5 zeigt den Verfahrensschritt der Abscheidung der zweiten Epi-Schicht 16 gemäss der zweiten Variante nach Fig. 1. Die Mesa-Oberfläche 13 ist jetzt sowohl von der Schicht 114 als auch von der Schicht 16 überdeckt. Notwendig ist, dass im Bereich der Mesa-Oberfläche 13 die Dicke der Schicht 16 geringer als im Bereich der Substratoberfläche 15 ist.

Zur Beseitigung des hier im Bereich der Mesa-Oberfläche 13 vorhandenen PN-Übergangs (zwischen dem Mesa 12 und der Schicht 114) wird das teilweise Wiederablösen gemäss diesem Verfahrensschritt der zweiten Variante (vierte Zeile in Fig. 1) durchgeführt, und zwar mit dem in Fig. 6 gezeigten Ergebnis. Das Wiederablösen von Material der Schichten 16 und 114 wird solange durchgeführt, bis die Mesa-Oberfläche 13 frei von solchem Material (der Schicht 114) ist, das dort einen PN-Übergang mit dem Material des Mesa 12 bzw. des Substratkörpers 11 bilden würde. Wegen der grösserem Dicke der Schicht 16 und gegebenenfalls auch 114 über der Substratoberfläche 15 verbleibt dort in jedem Fall eine restliche Schicht 114, so dass der PN-Übergang zwischen den Schichten 114 und 16 oberhalb der Substratoberfläche 15 ausserhalb des Mesa 12 unverändert erhalten bleibt.

Fig. 7 zeigt eine fertige Diode (nach der ersten Variante; bei der zweiten Variante wäre oberhalb der Mesa-Oberfläche 13 kein Anteil der Schicht 16 vorhanden), bei der auch die weiteren, dem Stand der Technik entsprechenden Schichten 17 und 18 zur Elektrolumineszenz-Erzeugung sowie die Elektroden 19 und 20 aufgebracht sind. Mit den beiden punktierten Kurvenzügen ist der Verlauf des elektrischen Stromes zwischen den Elektroden 19 und 20 durch die Diode hindurch angedeutet. Es ist deutlich ersichtlich, dass der Stromfluss 22 auf den Bereich der Mesa-Oberfläche 13 eingeengt ist, und zwar aufgrund des Vorhandenseins des sperrenden PN-Übergangs im Bereich der Substratoberfläche 15, nämlich benachbart bzw. ausserhalb rundherum um den Mesa 12 mit seiner Mesa-Oberfläche 13.

Mit 23 ist auf die bei Stromdurchfluss erzeugte Lumineszenz-Strahlung hingewiesen, die insbesondere bei einem Laser insbesondere auch als Strahlung 24 in lateraler (jedoch im Gegensatz zur Fig. 7 in zur Zeichenebene senkrechten) Richtung ausgesandt werden kann. Mit 25 ist in eine weitere Richtung emittierte Elektrolumineszenz-Strahlung bezeichnet.

Die durch Elektrolumineszenz erzeugte Emission der Strahlung erfolgt im Regelfall in einem Bereich der Schicht 17, in jedem Falle aber lateral beschränkt auf den Stromdurchflutungsbereich, der durch die Mesa-Oberfläche 13 relativ exakt definiert ist.

Ist z.B. nur Strahlungsaussendung in Richtung 23 erwünscht, kann vorteilhafterweise bei der Diode nach Fig. 7 eine spiegelnde Reflexionsschicht 26 vorgesehen sein, die Strahlung 25 in die gewünschte Richtung zurückreflektiert.

In Fig. 8 ist der Vollständigkeit halber noch ein Temperatur-Zeit-Diagramm 80 für die Verfahrensschritte der dritten und vierten Zeile der Fig. 1 gezeigt, und zwar für die zweite Variante (Fig. 3 und 5). Im Zeitraum $t_1$ bis $t_2$ erfolgt die Abscheidung der ersten Epi-Schicht 114, für die relativ starker zeitlicher Temperaturgradient vorgesehen sein kann. Im Zeitintervall $t_2$ bis $t_3$ erfolgt mit geringerem Temperaturgradienten (damit die Schichtdicke über der Mesa-Oberfläche geringer ist) die Abscheidung der zweiten Epi-Schicht 16. Im unmittelbar anschliessenden Zeitintervall $t_3$ bis $t_4$ erfolgt das teilweise Wiederablösen durch Temperaturerhöhung. Wie oben angedeutet, kann bei erneutem Absenken der Temperatur auch vorgesehen sein, dass zunächst bis $t^*_4 \rightarrow$ noch Material aus derselben Schmelzlösung wiederabgeschieden wird, nämlich als Schicht 116. In den Zeitintervallen $t_4$ bzw. $t^*_4$ bis $t_5$ und $t_5$ bis $t_6$ erfolgt das ebenfalls unmittelbar anschliessende Abscheiden der weiteren Schichten 17 und 18 bei weiterer Temperaturabsenkung 85. In den einzelnen Zeitintervallen wird z.B. nach der Technologie der Schiebe-Epitaxie jeweils die Schmelze mit dem betreffenden abzuscheidenden Halbleitermaterial aufgeschoben.

Der in Fig. 8 gestrichelt dargestellte alternative Temperaturverlauf 81 gilt für die erste Variante (Fig. 2 und Fig. 4) mit relativ langsamer Abscheidung im Zeitintervall $t_1$ bis $t_2'$, wobei die Schicht 14 mit über der Mesa-Oberfläche 13 geringerer Schichtdicke abgeschieden wird; das folgende Zeitintervalle $t_2'$ bis $t_3'$ entspricht dem des Wiederablösens und im Zeitintervall $t_3'$ bis $t_4$ erfolgt die Abscheidung der Schicht 16.

Im Zeitintervall $t_0$ bis $t_1$ erfolgt das anfängliche Aufheizen des mit dem Mesa bereits versehenen Substratkörpers 11 und der Schmelzen.

Die Fig. 8 zeigt mit dem Wiederanstieg in den Temperaturverläufen 80, 81 eine Möglichkeit für das gemäss einem Merkmal der Erfindung vorgesehene teilweise Wiederablösen des als Schicht zuvor abgeschiedenen Halbleitermaterials.

Fig. 9 zeigt, wie man auch mit einer zusätzlichen Ätzschmelze das Wiederablösen durchführen kann. In Fig. 9 ist mit 91 eine erste Schieberzunge einer prinzipiell bekannten Schiebe-Epitaxievorrichtung bezeichnet. Mit 92 ist die zur Aufnahme des Substratkörpers 11 vorgesehene Aussparung in der Zunge 91 bezeichnet. Die zweite Schieberzunge ist mit 93 bezeichnet, in der sich Ausnehmungen 94 bis 98 für die Aufnahme der einzelnen Schmelzen befinden. In der Aufnahme 94 befindet sich die Schmelzlösung für die erste Schicht 14 bzw. 114, in der Ausnehmung 96 befindet sich die Schmelzlösung für die zweite Schicht 16 und in den Ausnehmungen 97 und 98 befinden sich die Schmelzlösungen für die weiteren Schichten 17 und 18. Die Ausnehmung 95 ist für eine Ätzschmelze 99 vorgesehen. Diese Ätzschmelze 99 ist z.B. eine Gallium- oder Indiumschmelze, in der in unzureichendem Masse abzuscheidendes Halbleitermaterial enthalten ist, so dass diese Schmelze 99 eine hohe Tendenz hat, solches Halbleitermaterial aufzulösen, mit dem diese Schmelze 99 in Berührung kommt. Bei der Darstellung der Fig. 9 ist dies das Halbleitermaterial der Schicht 14, das zuvor aus der Schmelzlösung 94 abgeschieden worden war, als sich diese Ausnehmung 94 noch über der Ausnehmung 92 befand und noch nicht durch Verschieben der Schieberzunge 93 in Richtung des Pfeils 100 (relativ zur Zunge 91) in die in Fig. 9 gezeigte Position verschoben worden ist. Die Ätzschmelze 99 belässt man solange über der Ausnehmung 92 und damit über dem Substratkörper 11 mit seiner ersten Epi-Schicht 14, wie dies zu dem oben ausführlich beschriebenen Wiederablösen von Halbleitermaterial der Schicht 14 notwendig ist. Für den nächsten Verfahrensschritt wird die Schieberzunge 93 dann weiterverschoben, so dass die Ausnehmung 96 über die Ausnehmung 92 gelangt, nämlich um die nächste Schicht 16 abzuscheiden.

Für die oben beschriebene zweite Variante wären die Positionen der Ätzschmelze 99 und der Schmelzlösung der Ausnehmung 96 miteinander zu vertauschen, so dass beim Verschieben der Zunge 93 entsprechend dem Pfeil 100 zunächst erst die erste Epi-Schicht 114 aus der Schmelzlösung der Ausnehmung 94 und dann die zweite Epi-Schicht 16 aus der benachbarten Schmelzlösung abgeschieden wird, und erst dann die Ausnehmung mit der Ätzschmelze 99 über den Substratkörper 11 mit seinen beiden Schichten 114 und 16 gelangt.

Es sei darauf hingewiesen, dass die Höhe des angedeuteten Mesa 12 so gering ist, dass dies das übliche Schiebe-Epitaxieverfahren, wie es auch in Fig. 9 vorgesehen ist, nicht behindert.

Die Epitaxievorrichtung nach Fig. 9 kann auch für das spezielle Verfahren nach Fig. 8 mit Wiederauflösen mittels einer Schmelzlösung, die primär für Epitaxieabscheidung verwendet wird, benutzt werden, wobei dann die Ätzschmelze 99 entfällt und nur Schmelzlösungen 94, 96, 97, 98 aufeinanderfolgend mit der oberen Schieberzunge über den Substratkörper 11 in der Ausnehmung 92 der unteren Schieberzunge 91 hinweggeschoben werden.

## Patentansprüche

1. Verfahren zur Herstellung einer mit Elektroden versehenen pn-Lumineszenz- oder Laserdiode mit einem durch seitliche Begrenzung mittels eines pn-Übergangs definierten Emissionsbereiches im Halbleiterkörper dieser Diode, wobei
– in einem ersten Verfahrensschritt auf dem Substratkörper (11) aus Halbleitermaterial eines ersten Leitungstyps ein Mesa (12) erzeugt wird, dessen Oberfläche (13) entsprechend dem geforderten Emissionsbereich bemessen ist,
– in einem zweiten Verfahrensschritt eine Schicht (14) aus Halbleitermaterial des entgegengesetzten zweiten Leitungstyps auf der Substratoberfläche (15) und dem Mesa (12, 13) abgeschieden wird, wobei durch im Vergleich zu den übrigen Epitaxieschritten langsames Absenken der Temperatur der Schmelze und daraus resultierendes, relativ langsames epitaktisches Aufwachsen diese Schicht (14) im Bereich der Mesa-Oberfläche (13) mit geringerer Dicke als auf der darum herum befindlichen Substratoberfläche (15) erzeugt wird,
– in einem dritten Verfahrensschritt von dieser Schicht (14) wieder ein so grosser Anteil mittels der Schmelzlösung des vorangegangenen Verfahrensschrittes bzw. mit der Schmelzlösung des folgenden Verfahrensschrittes bei zeitweiser Temperaturerhöhung bzw. mittels einer gesonderten Ätz-/Abtragschmelze bei auch gleichbleibender Temperatur abgelöst wird, dass die ganze Mesa-Oberfläche (13) zumindest freigelegt ist,
– in einem vierten Verfahrensschritt eine weitere Schicht (16) aus Halbleitermaterial des ersten Leitungstyps auf der Schicht (14) des zweiten Verfahrensschrittes und der freigelegten Mesa-Oberfläche (13) epitaktisch abgeschieden wird und
– in weiteren, an sich bekannten Verfahrensschritten die Schichtfolge (17, 18) an sich bekannter Lumineszenz- oder Laserdioden epitaktisch aufgebracht wird.

2. Verfahren zur Herstellung einer mit Elektroden versehenen pn-Lumineszenz- oder Laserdiode mit einem durch seitliche Begrenzung mittels eines pn-Übergangs definierten Emissionsbereiches im Halbleiterkörper dieser Diode, wobei
– in einem ersten Verfahrensschritt auf dem Substratkörper (11) aus Halbleitermaterial eines ersten Leitungstyps ein Mesa (12) erzeugt wird, dessen Oberfläche (13) entsprechend dem geforderten Emissionsbereich bemessen ist,
– in einem zweiten Verfahrensschritt eine Schicht (114) aus weiterem Halbleitermaterial mit entgegengesetztem zweiten Leitungstyp auf der Substratoberfläche (15) und dem Mesa (12, 13) abgeschieden wird, wobei durch relativ langsames Absenken der Temperatur der Schmelze und daraus resultierendes, relativ langsames epitaktisches Aufwachsen diese Schicht (114) im Bereich der Mesa-Oberfläche (13) mit geringerer Dicke als auf der darum herum befindlichen Substratoberfläche (15) erzeugt wird,
– in einem dritten Verfahrensschritt eine weitere Schicht (16) aus Halbleitermaterial des ersten Leitungstyps abgeschieden wird, wobei durch relativ langsames Absenken der Temperatur der Schmelze und daraus resultierendes relativ langsames epitaktisches Aufwachsen diese Schicht (16) im Bereich des Mesa (12) mit geringerer Dicke als auf der übrigen Oberfläche der Schicht (114) des zweiten Verfahrensschrittes erzeugt wird,
– in einem vierten Verfahrensschritt die Schicht (16) des dritten Verfahrensschrittes und die Schicht (114) des zweiten Verfahrensschrittes auf der Mesa-Oberfläche (13) mittels der Schmelzlösung des vorangegangenen Verfahrensschrittes bzw. mit der Schmelzlösung des folgenden Verfahrensschrittes bei zeitweiser Temperaturerhöhung bzw. mittels einer gesonderten Ätz-/Abtragschmelze bei auch gleichbleibender Temperatur wieder abgelöst werden, so dass die ganze Mesa-Oberfläche (13) vom Material der Schicht (114) des zweiten Verfahrensschrittes freigelegt ist, und
– in weiteren, an sich bekannten Verfahrensschritten die Schichtfolge (17, 18) an sich bekannter Lumineszenz- oder Laserdioden epitaktisch aufgebracht wird.

3. Verfahren nach Anspruch 1 oder 2, gekennzeichnet dadurch, dass der Mesa (12) durch Ätzen des Substratkörpers (11) aus diesem hergestellt wird.

4. Verfahren nach Anspruch 1, 2 oder 3, gekennzeichnet dadurch, dass das Ablösen zuvor abgeschiedenen Halbleitermaterials (14; 114, 16) durch Abätzen erfolgt, wofür eine zusätzliche Ätzschmelze (99) verwendet wird.

5. Verfahren nach Anspruch 1, 2 oder 3, gekennzeichnet dadurch, dass das Wiederablösen von zuvor abgeschiedenem Halbleitermaterial (14; 114, 16) durch Wiederauflösen vorgenommen wird, indem die Temperatur der Schmelze des betreffenden Verfahrensschrittes vorübergehend erhöht wird $(t_2'-t_3'; t_3-t_4)$.

6. Verfahren nach Anspruch 5, rückbezogen auf Anspruch 1 oder 3, gekennzeichnet dadurch, dass das mit Temperaturerhöhung erfolgende Wiederablösen zuvor abgeschiedenen Halbleitermaterials (14) mit der Schmelzlösung erfolgt, aus der das Material der folgenden Schicht (16) abzuscheiden ist.

## Claims

1. Process for the production of a pn light-emitting diode or laser diode, provided with electrodes, having an emission area, defined by lateral limitation by means of a pn junction, in the semiconductor body of this diode,

– in a first process step a mesa (12) being produced on the substrate body (11) consisting of semiconductor material of a first type of conduction, the surface (13) of which mesa is dimensioned so as to correspond to the required emission area,

– in a second process step a layer (14) consisting of semiconductor material of the opposite second type of conduction being deposited on the substrate surface (15) and the mesa (12, 13), this layer (14) being produced in the region of the mesa surface (13) with smaller thickness than on the substrate surface (15) situated around the same, as a result of lowering – which is slow in comparison with the remaining epitaxy steps – of the temperature of the melt and relatively slow epitaxial growth resulting therefrom,

– in a third process step such a large proportion of this layer (14) being removed again by means of the melt solution of the preceding process step or with the melt solution of the following process step with temporary increasing of the temperature or by means of a separate etching/erosion melt, at a temperature which may as well be kept constant, that the entire mesa surface (13) is at least cleared,

– in a fourth process step a further layer (16) consisting of semiconductor material of the first type of conduction being epitaxially deposited on the layer (14) of the second process step and the cleared mesa surface (13), and

– in further process steps known per se the sequence of layers (17, 18) of light-emitting diodes or laser diodes known per se being epitaxially applied.

2. Process for the production of a pn light-emitting diode or laser diode, provided with electrodes, having an emission area, defined by lateral limitation by means of a pn junction, in the semiconductur body of this diode,

– in a first process step a mesa (12) being produced on the substrate body (11) consisting of semiconductor material of a first type of conduction, the surface (13) of which mesa is dimensioned so as to correspond to the required emission area,

– in a second process step a layer (114) consisting of further semiconductor material having the opposite second type of conduction being deposited on the substrate surface (15) and the mesa (12, 13), this layer (114) being produced in the region of the mesa surface (13) with smaller thickness than on the substrate surface (15) situated around the same, as a result of relatively slow lowering of the temperature of the melt and relatively slow epitaxial growth resulting therefrom,

– in a third process step a further layer (16) consisting of semiconductor material of the first type of conduction being deposited, this layer (16) being produced in the region of the mesa (12) with smaller thickness than on the remaining surface of the layer (114) of the second process step, as a result of relatively slow lowering of the temperature of the melt and relatively slow epitaxial growth resulting therefrom,

– in a fourth process step the layer (16) of the third process step and the layer (114) of the second process step on the mesa surface (13) being removed again by means of the melt solution of the preceding process step or with the melt solution of the following process step with temporary increasing of the temperature or by means of a separate etching/erosion melt, at a temperature which may as well be kept constant, so that the entire mesa surface (13) is cleared of the material of the layer (114) of the second process step, and

– in further process steps known per se the sequence of layers (17, 18) of light-emitting diodes or laser diodes known per se being epitaxially applied.

3. Process according to Claim 1 or 2, characterized in that the mesa (12) is produced by etching of the substrate body (11), from the latter.

4. Process according to Claim 1, 2 or 3, characterized in that the removal of previously deposited semiconductor material (14; 114, 16) takes place by etching away, for which an additional etching melt (99) is employed.

5. Process according to Claim 1, 2 or 3, characterized in that the removal again of previously deposited semiconductor material (14; 114, 16) is carried out by redissolving, in that the temperature of the melt of the pertinent process step is transitorily increased ($t_2'-t_3'$; $t_3-t_4$).

6. Process according to Claim 5, appendant to Claim 1 or 3, characterized in that the removal again of previously deposited semiconductor material (14), taking place by increasing the temperature, takes place with the melt solution from which the material of the following layer (16) is to be deposited.

**Revendications**

1. Procédé pour la fabrication d'une diode électroluminescente ou laser PN, pourvue d'électrodes et possédant une région d'émission délimitée latéralement par une jonction PN dans le corps semi-conducteur, selon lequel

– on crée, dans une première opération, un plateau (12) sur le substrat (11) en matériau semi-conducteur d'un premier type de conductivité, plateau dont la surface (13) est dimensionnée conformément à la région d'émission requise,

– on dépose, dans une deuxième opération, une couche (14) de matériau semi-conducteur d'un second type de conductivité opposé au premier sur la surface (15) du substrat et sur le plateau (12, 13), en réalisant cette couche (14) avec une plus faible épaisseur dans la région de la surface (13) du plateau que sur la surface (15) du substrat autour du plateau, par abaissement lent de la température du bain, comparativement aux autres opérations d'épitaxie et par la croissance épitaxiale relativement lente de cette couche (14), croissence lente qui est due à l'abaissement de la température,

— on dissout de nouveau, dans une troisième opération, une si grande partie de cette couche (14), au moyen de la solution de fusion de l'opération précédente, ou au moyen de la solution de fusion de l'opération consécutive, en augmentant temporairement la température, ou encore au moyen d'un bain particulier de gravure ou d'enlèvement particulier, avec lequel la température peut également rester constante, qu'au moins toute la surface (13) du plateau est dégagée,

— on dépose par épitaxie, dans une quatrième opération, une couche supplémentaire (16) de matériau semi-conducteur du premier type de conductivité sur la couche (14) déposée par la deuxième opération et sur la surface (13) dégagée du plateau et

— on applique, par épitaxie, en d'autres opérations, en elles-mêmes connues, la succession de couches (17, 18) de diodes électroluminescentes ou de diodes laser en elles-mêmes connues.

2. Procédé pour la fabrication d'une diode électroluminescente ou laser PN, pourvue d'électrodes et possédant une région d'émission délimitée latéralement par une jonction PN dans le corps semi-conducteur de cette diode, selon lequel

— on crée, dans une première opération, un plateau (12) sur le substrat (11) en matériau semi-conducteur d'un premier type de conductivité, plateau dont la surface (13) est dimensionnée conformément à la région d'émission requise,

— on dépose, dans une deuxième opération, une couche (114) d'un autre matériau semi-conducteur d'un second type de conductivité opposé au premier sur la surface (15) du substrat et sur le plateau (12, 13), en réalisant cette couche (114) avec une plus faible épaisseur dans la région de la surface (13) du plateau que sur la surface (15) du substrat autour du plateau, par abaissement relativement lent de la température du bain et par la croissance épitaxiale relativement lente de cette couche (114), croissance lente qui est due à l'abaissement de la température,

— on dépose, dans une troisième opération, une couche supplémentaire (16) de matériau semi-conducteur du premier type de conductivité, en réalisant cette couche (16) avec une plus faible épaisseur dans la région du plateau (12) que sur le reste de la surface de la couche (114) formée par la deuxième opération, par un abaissement relativement lent de la température du bain et par la croissance épitaxiale relativement lente de cette couche (16), croissance lente qui est due à l'abaissement de la température,

— on dissout de nouveau, dans une quatrième opération, la couche (16) formée par la troisième opération et la couche (114) formée par la deuxième opération sur la surface (13) du plateau, au moyen de la solution de fusion de l'opération précédente ou au moyen de la solution de fusion de l'opération consécutive, avec augmentation temporaire de la température, ou encore au moyen d'un bain particulier de gravure ou d'enlèvement, avec lequel la température peut également rester constante, de manière que toute la surface (13) du plateau soit débarrassée de matériau de la couche (114) formée par la deuxième opération, et

— on applique par épitaxie, en d'autres opérations, en elles-mêmes connues, la succession de couches (17, 18) de diodes électroluminescentes ou de diodes laser en elles-mêmes connues.

3. Procédé selon la revendication 1 ou 2, caractérisé en ce que l'on forme le plateau (12) à partir du substrat (11) par gravure de celui-ci.

4. Procédé selon la revendication 1, 2 ou 3, caractérisé en ce que l'on effectue la dissolution de matériau semi-conducteur (14; 114, 16) déposé précédemment par gravure, en utilisant un bain de gravure (99) supplémentaire.

5. Procédé selon la revendication 1, 2 ou 3, caractérisé en ce que l'on effectue la redissolution de matériau semi-conducteur (14; 114, 16) déposé précédemment en augmentant temporairement la température du bain utilisée pour l'opération de dépôt concernée $(t_2'-t_3'; t_3-t_4)$.

6. Procédé selon la revendication 5 dépendante de la revendication 1 ou 3, caractérisé en ce que la redissolution de matériau semi-conducteur (14) précédemment déposé, redissolution qui est produite par élévation de la température, est réalisée au moyen de la solution de fusion à partir de laquelle le matériau de la couche (16) suivante est à déposer.

FIG 1

```
                        ┌─────────────────┐
                        │   Substrat-     │      N-oder P-Typ
                        │   körper (11)   │
                        └────────┬────────┘
                                 │
                        ┌────────┴────────┐
                        │   Ätzen des     │
                        │   Mesa (12)     │
                        └────────┬────────┘
                                 │
           ┌─ ─ ─ ─ ─ ─ ─ ─ ─ ─ ┴ ─ ─ ─ ─ ─ ─ ─ ─ ─ ─ ─ ─┐
           │                                               │
  ┌────────┴──────────┐                          ┌─────────┴──────────┐
  │ 1 Epischicht (14) │ ←(P-oderN-Typ)→          │ 1 Epischicht (114) │
  │         +         │                          └─────────┬──────────┘
  │    teilweises     │                                    │
  │   Wiederablösen   │                          ┌─────────┴──────────┐
  └────────┬──────────┘              ┌──────────→│ 2 Epischicht (16)  │
           │                         │           │         +          │
  ┌────────┴──────────┐   (N-oderP-Typ)          │     teilweises     │
  │ 2. Epischicht (16)│ ←─┘                      │    Wiederablösen   │
  └────────┬──────────┘                          └─────────┬──────────┘
           │                                               │
           └─ ─ ─ ─ ─ ─ ─ ─ ─ ─ ┬ ─ ─ ─ ─ ─ ─ ─ ─ ─ ─ ─ ─┘
                                 │
                        ┌────────┴────────┐
                        │   Aufwachsen    │
                        │  der weiteren   │
                        │ Schichten(17,18)mit│
                        │ Elektrolumineszens-│
                        │     effekt      │
                        └────────┬────────┘
                                 │
                        ┌────────┴────────┐
                        │   Elektroden    │
                        └────────┬────────┘
                                 │
                        ┌────────┴────────┐
                        │  fertige Diode  │
                        └─────────────────┘
```

FIG 2

FIG 3

FIG 4

FIG 5

FIG 6

FIG 7

# FIG 8

# FIG 9